Europäisches Patentamt

European Patent Office

Office européen des brevets

(19)

(11) Publication number: **0 034 001**
**B1**

(12) **EUROPEAN PATENT SPECIFICATION**

(45) Date of publication of patent specification: **21.09.83**

(21) Application number: **81300037.9**

(22) Date of filing: **06.01.81**

(51) Int. Cl.³: **H 01 L 23/48,**
**H 01 L 23/36, H 01 L 21/60**

(54) IC chip mounting assembly and a method of manufacturing such assembly.

(30) Priority: **18.01.80 US 113159**

(43) Date of publication of application:
**19.08.81 Bulletin 81/33**

(45) Publication of the grant of the patent:
**21.09.83 Bulletin 83/38**

(84) Designated Contracting States:
**AT BE CH DE FR GB IT LI NL SE**

(56) References cited:
**EP - A - 0 001 892**
**DE - A - 2 714 483**
**US - A - 3 574 815**

(73) Proprietor: **AMP INCORPORATED**
**Eisenhower Boulevard**
**Harrisburg Pennsylvania (US)**

(72) Inventor: **Keller, Joseph Richard**
**2406 Walker Mill Road R.D. No. 2**
**Harrisburg Pennsylvania 17110 (US)**
Inventor: **Olsson, Billy Erik**
**709 Drexel Hills Boulevard**
**New Cumberland Pennsylvania 17070 (US)**

(74) Representative: **Wayte, Dennis Travers et al,**
**20 Queensmere**
**Slough, Berkshire SL1 1YZ (GB)**

Courier Press, Leamington Spa, England.

IC chip mounting assembly and a method of manufacturing such assembly

This invention relates to an IC chip mounting assembly and to a method of manufacturing such assembly.

An IC chip mounting assembly is known from EP—A—0 001 892 (European Patent Application No. 78300494.8), which comprises a lead frame providing a plurality of leads for connection to contact points on the chip, a heat sink to which the chip is to be bonded by means of solder, and an insulating housing mounted on the heat sink and leads and providing a cavity in which the chip is to be received with solder thereunder to bond the chip to the heat sink.

It is also known, for example from U.S. Patent Specifications Nos. 3,597,666, 3,778,887 and 3,821,615, for the heat sink to be provided as an integral part of the lead frame, and for the housing to be moulded about portions of the heat sink and leads.

A known method of manufacturing such an assembly involves positioning the chip in the housing cavity with a solder blank thereunder, the solder blank lying on the heat sink, and then passing the assembly through an oven whereby the solder is melted such that with subsequent cooling of the solder the chip is bonded to the heat sink by the solder.

Disadvantages of known such assemblies and their method of manufacture are that it is difficult to position the chip accurately in the housing cavity; that often after melting of the solder blank there is an excess of molten solder which flows around and possibly over the chip whereby short circuits between the contact points on the chip are formed; and that the use of an oven to effect melting of the solder necessitates the whole assembly to be heated thus giving the possibility of damage to the normally thermoplastic material housing.

According to this invention there is provided an IC chip mounting assembly comprising a lead frame providing a heat sink to which the chip is to be bonded by means of solder and a plurality of leads for connection to contact points on the chip, and further comprising an insulating housing moulded about portions of the heat sink and of the leads, which housing provides a cavity in which the chip is to be received with a solder blank thereunder for subsequent melting of the solder blank to bond the chip to the heat sink, characterised in that the housing has a bottom wall formed on the heat sink, the bottom wall having an aperture thereon through which the heat sink is exposed to the cavity, the aperture being shaped to receive the chip with the solder blank thereunder and position the chip on the heat sink, there being a number of solder wells positioned around and in communication with the aperture.

Also according to this invention there is provided a method of manufacturing an assembly as set out in the preceding paragraph characterised by the steps of positioning a solder blank and an IC chip in the aperture in the bottom wall of the housing with the solder blank located between the chip and the heat sink; urging the chip towards the heat sink with a predetermined force; heating the solder blank thereby to cause the solder blank to melt, the force applied to the chip then causing the solder to asssume a predetermined thickness with excess solder flowing into the solder wells; and then allowing the solder to set and thus bond the chip to the heat sink.

Preferably the solder blank is melted by the use of an induction heating apparatus operative to induce a heating current in the solder blank.

This invention will now be described by way of example with reference to the drawings, in which:—

Figure 1 is a perspective view of a transistor according to the invention;

Figure 2 is a perspective view of part of a strip of lead frames prior to moulding of housings thereon during manufacture of assemblies according to the invention;

Figure 3 is a perspective view of part of the strip of Figure 2 with housings moulded thereon;

Figure 4 is a top plan view of a lead frame and housing as shown in Figure 3;

Figure 5 is a sectional view on the line V—V in Figure 4 and showing a solder blank and an IC chip for mounting on the assembly;

Figure 6 is a view similar to Figure 5 but showing the chip bonded to the heat sink of the lead frame;

Figure 7 is a sectional view on the line VII—VII in Figure 1;

Figure 8 is a diagrammatic perspective view of an induction heating apparatus used for bonding the chip to the heat sink of the lead frame; and

Figure 9 is a sectional view through part of the apparatus of Figure 8.

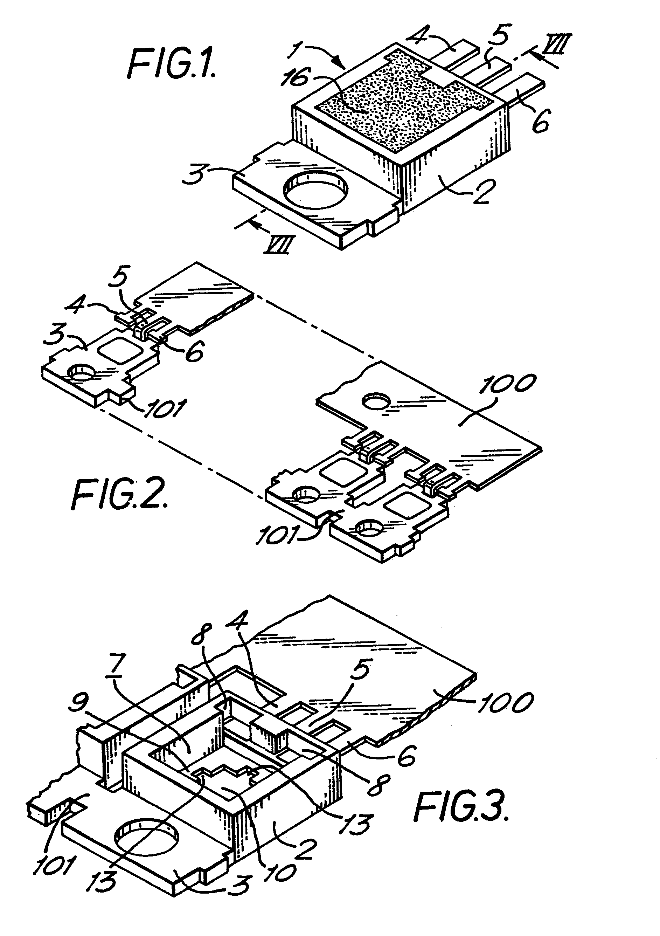

Referring to the drawings, the transistor 1, shown in Figure 1, comprises a generally rectangular cross-section housing 2 moulded from electrically insulating material such as a filled nylon composition, on to a lead frame, as shown in Figure 2, comprising a heat sink 3 and three leads 4, 5 and 6, all of which project from the housing 2.

As shown in Figure 2, the lead frame providing the heat sink 3 and leads 4, 5 and 6 are formed in known manner as part of a strip with the leads 4, 5 and 6 projecting from one edge of a carrier strip 100, and the heat sink members 3 of adjacent lead frames are connected by slugs 101. The two outer leads 4 and 6 project in cantilever manner from the carrier strip 100 and have enlarged free end portions, while the centre lead 5 extends from the carrier strip 100 initially coplanar with the leads 4 and 6, and is then bent through approximately 90° with the end remote from the carrier strip being connected to the heat sink 3 which lies in a plane parallel to but spaced from that of the carrier strip 100 and leads 4 and 6. As best seen in Figure 2, the heat sink 3 is thicker than the carrier strip 100 and leads 4, 5 and 6, this thickness being such as to provide the necessary heat absorption properties for the heat sink 3. The strip of lead frames as shown in Figure 2 can be manufactured in known manner, for example by blanking a first strip comprising the carrier strip 100 and the leads 4, 5 and 6, and blanking a second strip comprising the heat sinks 3 and the connecting slugs 101, and then connecting the two strips by mechanically connecting the ends of the leads 5 of the lead frames to respective heat sinks 3.

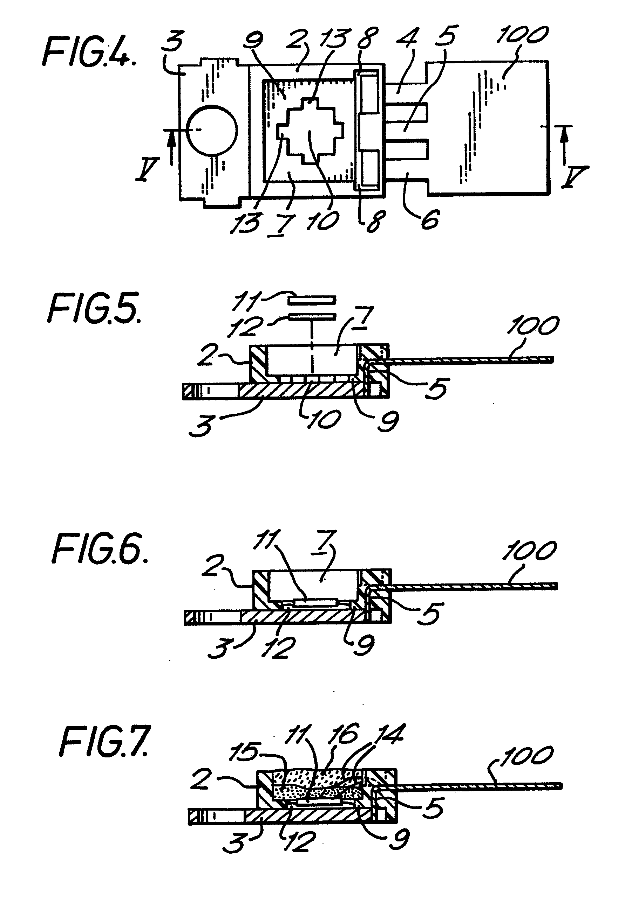

Assemblies are then formed by moulding a housing 2 on to each lead frame, as shown in Figures 3 and 4, to leave portions of the leads 4, 5 and 6 exposed between the housing 2 and the carrier strip 100, and a portion of the heat sink 3 exposed at the opposite side of the housing 2. Each housing 2 is formed with a central cavity 7 to receive an IC chip and sealing material, as will be described later, this central cavity 7 communicating with two smaller recesses 8 in which the enlarged free end portions of the leads 4 and 6 are exposed, respectively.

Referring now to Figures 5 to 7 also, the housing 2 has a bottom wall 9 formed on the surface of the heat sink 3. This bottom wall 9 has an aperture 10 therein, through which aperture 10 the heat sink 3 is exposed to the cavity 7. The aperture 10 is shaped to receive an IC chip 11 and an underlying similarly shaped solder blank 12 thereby accurately to position the chip 11 on the heat sink 3. In the embodiment being described the chip 11 is substantially square in plan view and thus the aperture 10 is also square in plan view, as shown in Figure 4.

Positioned around the aperture 10 and in communication therewith are a number (in this embodiment four) of solder wells 13 through which the surface of the heat sink 3 is exposed. These solder wells 13 are not filled when the solder blank 12 and chip 11 are initially positioned in the cavity 7, but when the solder 12 is then melted, as will be described later, to bond the chip 11 to the heat sink 3 as required, the solder wells 13 receive any excess solder which flows out from under the chip 11, whereby this excess solder is prevented from flowing around and possibly over the chip 11 and thus shorting out the contact points on the chip 11.

After the chip 11 has been bonded to the heat sink 3, as shown in Figure 6, contact points on the chip 11 are connected to the enlarged end portions of the leads 4 and 6 by way of fine wires 14, in known manner, as shown in Figure 7. Thus, the three electrodes of the transistor chip 11 are connected to the three leads 4, 5 and 6 of the lead frame, respectively. The chip 11 is then covered by a layer 15 of a silicone gel or similar material which does not harden, the gel in turn being covered by a layer 16 of an epoxy resin which does harden, thereby to seal the cavity 7 with the chip 11 therein. The layer 15 of gel is not essential; the cavity 7 can otherwise be filled with epoxy resin material only.

A chip 11 can be mounted in each housing 2 as described above while the housing 2 is still part of a strip as shown in Figure 3. Otherwise the strip can be cut to provide individual lead frame/housing assemblies as shown in Figure 4 prior to mounting of a chip 11 therein. In either event, the carrier strip 100 is removed after mounting of the chip 11 to leave a transistor comprising a chip 11 sealed in a housing 2 and mounted on a lead frame providing a heat sink 3 and three connection leads 4, 5 and 6, as shown in Figure 1.

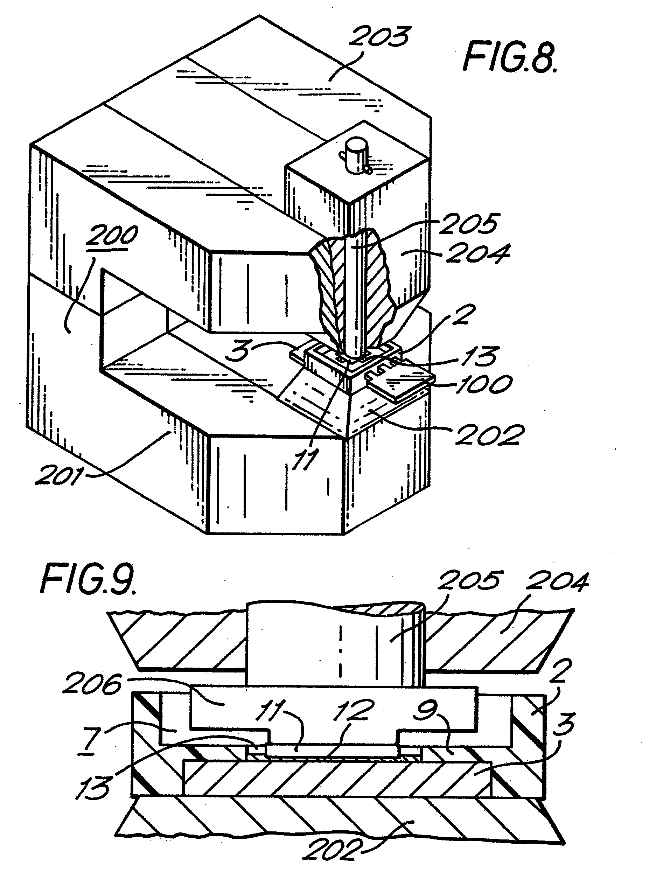

The chip 11 can be bonded to the heat sink 3 by the use of induction heating apparatus which serves to melt the solder blank 12 as required, such an apparatus being shown in Figures 8 and 9. This apparatus comprises a C-shaped core 200 around the bight of which an exciting coil (not shown) would be provided. One arm 201 of the core 200 carries a work support table 202, while the other arm 203 carries a slidable ram 204 in which a hold-down rod 205 of insulating material is slidably mounted. A clamping member 206 (Figure 9) of insulating material is mounted on the rod 205, and may be formed integrally therewith.

For use, the lead frame/housing assembly with the solder blank 12 and chip 11 therein is mounted on the table 202 possibly with an insulating film (not shown) positioned therebetween. The ram 204 is then lowered and locked in a position with its end adjacent to but spaced from the top of the housing 2. The chip 11 is thus engaged by the clamping member 206 which holds the assembly on the table 202 with a predetermined light force determined by the weight of the rod 205 and clamping member 206. The coil (not shown) is then energised and the flux thus induced in the core 200 passes through and induces a current in the solder blank 12, whereby the solder blank 12 is melted with excess solder flowing into the solder wells 13 as described above, the thickness of the layer of solder remaining under the chip 11 being determined by the clamping force being applied to the chip 11. The solder wells 13 also permit the escape of any gases which might otherwise build up under or around the chip 11 during melting of the solder blank 12. On de-energising of the coil and raising of the rod 205 the solder will solidify and the assembly can be removed from the table 202 with the chip 11 bonded to the heat sink 3, and ready for introduction of the gel 15 and resin 16, as shown in Figure 7.

Use of the method of bonding described above permits precise control of the thickness of solder remaining under the chip 11, a thickness of 25.40 $\mu$m (0.001 inches) generally being considered as optimum, with any excess solder pressed out by the rod 205 being contained in the solder wells 13. Further, since bonding of the chip 11 is carried out using a localised heating source there is no possibility of damage to the housing 2 as can occur with the conventional method of effecting bonding comprising passing the housing with the solder and chip therein through an oven.

## Claims

1. An IC chip mounting assembly comprising a lead frame providing a heat sink (3) to which the chip (11) is to be bonded by means of solder (12) and a plurality of leads (4, 5, 6) for connection to contact points on the chip (11), and further comprising an insulating housing (2) moulded about portions of the heat sink (3) and of the leads (4, 5, 6) which housing provides a cavity (7) in which the chip (11) is to be received with a solder blank (12) thereunder for subsequent melting of the solder blank (12) to bond the chip (11) to the heat sink (3) characterised in that the housing (2) has a bottom wall (9) formed on the heat sink (3), the bottom wall (9) having an aperture (10) therein through which the heat sink (3) is exposed to the cavity (7), the aperture (10) being shaped to receive the chip (11) with the solder blank (12) thereunder and position the chip (11) on the heat sink (3), there being a number of solder wells (13) positioned around and in communication with the aperture (10).

2. An assembly as claimed in Claim 1, characterised in that the aperture (10) in the bottom wall (9) of the housing (2) is rectangular, there being a solder well (13) in communication with each edge of the aperture (10).

3. An assembly as claimed in Claim 1 or Claim 2, characterised in that there are three leads (4, 5, 6), one lead (5) being directly connected to the heat sink (3), and the other two leads (4, 6) having portions exposed in recesses (8) in the housing (2) and in communication with the cavity (7).

4. An assembly as claimed in any preceding claim, characterised by an IC chip (11) received in the aperture (10) in the bottom wall (9) of the housing (2) and secured to the heat sink (3) by solder (12) in the aperture (10) between the chip (11) and the heat sink (3), there also being solder (12) in the solder well or wells (13).

5. An assembly as claimed in Claim 4 as dependent upon Claim 3, characterised in that contact points on the chip (11) are connected by conductors (14) to the portions of the other two leads (4, 6) exposed in the recesses (8).

6. An assembly as claimed in Claim 5, characterised in that the cavity (7) is filled with insulating material (15, 16) at least on outer layer (16) of which is solidified.

7. A method of manufacturing an assembly as claimed in Claim 4, 5 or 6, characterised by the steps of positioning a solder blank (12) and an IC chip (11) in the aperture (10) in the bottom wall (9) of the housing (2) with the solder blank (12) located between the chip (11) and the heat sink (3); urging the chip (11) towards the heat sink (3) with a predetermined force; heating the solder blank (12) thereby to cause the solder blank (12) to melt, the force applied to the chip (11) then causing the solder (12) to assume a predetermined thickness with excess solder (12) flowing into the solder wells (13); and then allowing the solder (12) to set and thus bond the chip (11) to the heat sink.

8. A method as claimed in Claim 7, characterised in that the solder blank (12) is melted by the use of an induction heating apparatus operative to induce a heating current in the solder blank (12).

## Revendications

1. Ensemble de montage d'une puce de circutis intégrés comprenant un cadre de montage présentant un élément (3) de refroidissement sur lequel la puce (11) est destinée à être liée au moyen d'une soudure (12) et plusieurs conducteurs (4, 5 et 6) destinés à une connexion sur des points de contact sur la puce (11), et comprenant en outre un corps isolant (2) moulé autour de certaines parties de l'élément (3) de refroidissement et des conducteurs (4, 5 et 6), lequel corps présente une cavité (7) dans laquelle la puce (11) est destinée à être reçue, un flan (12) de soudure étant placé au-dessous d'elle pour être ensuite amené à l'état de fusion afin de lier la puce (11) à i'élément (3) de refroidissement, caractérisé en ce que le corps (2) comporte une paroi (9) de fond formée sur l'élément (3) de refroidissement, la paroi (9) de fond présentant une ouverture (10), à travers laquelle l'élément (3) de refroidissement est exposé à la cavité (7), l'ouverture (10) étant configurée afin de recevoir la puce (11), le flan (12) de soudure étant placé sous elle, et de positionner la puce (11) sur l'élément (3) de refroidissement, un certain nombre d'alvéoles 13 de soudure étant positionnés autour de et communiquant avec l'ouverture (10).

2. Ensemble selon la revendication 1, caractérisé en ce que l'ouverture (10) de la paroi (9) de fond du corps (2) est rectangulaire, un alvéole (13) de soudure étant en communication avec haque bord de l'ouverture (10).

3. Ensemble selon la revendication 1 ou la revendication 2, caractérisé en ce qu'il y a trois conducteurs (4, 5 et 6), un conducteur (5) étant connecté directement à l'élément (3) de refroidissement, les deux autres conducteurs (4 et 6) comportant des tronçons exposés dans des évidements (8) du corps (2), et en communication avec la cavité (7).

4. Ensemble selon l'une quelconque des revendications précédentes, caractérisé par une puce (11) de circuits intégrés reçue dans l'ouverture (10) de la paroi (9) de fond du corps (2) et fixée à l'élément (3) de refroidissement par de la soudure (12), dans l'ouverture (10) entre la puce (11) et l'élément (3) de refroidissement, de la soudure (12) se trouvant également dans l'alvéole ou les alvéoles (13) de soudure.

5. Ensemble selon la revendication 4, en dépendance de la revendication 3, caractérisé en ce que des points de contact sur la puce (11) sont connectés par des conducteurs (14) aux tronçons des deux autres conducteurs (4 et 6), exposés dans les évidements (8).

6. Ensemble selon la revendication 5, caractérisé en ce que la cavité (7) est remplie d'une matière isolante (15, 16) dont au moins une couche extérieure (16) est solidifiée.

7. Procédé de fabrication d'un ensemble selon la revendication 4, 5 ou 6, caractérisé par les étapes qui consistent à positionner un flan (12) de soudure et une puce (11) de circuits intégrés dans l'ouverture (10) ménagée dans la paroi (9) de fond du corps (2), le flan (12) de soudure étant placé entre la puce (11) et l'élément (3) de refroidissement; à solliciter la puce (11) vers l'élément (3) de refroidissement sous une force prédéterminée; à chauffer le flan (12) de soudure afin de provoquer sa fusion, la force appliquée à la puce (11) donnant alors à la soudure (12) une épaisseur prédéterminée, l'excédent de soudure (12) s'écoulant dans les alvéoles (13) de soudure; et à permettre, ensuite, à la soudure (12) de prendre et de lier ainsi la puce (11) à l'élement de refroidissement.

8. Procédé selon la revendication 7, caractérisé en ce que le flan (12) de soudure est amené à l'état de fusion par l'utilisation d'un appareil de chauffage par induction, agissant de façon à induire un courant de chauffage dans le flan (12) de soudure.

**Patentansprüche**

1. Montierungsanordung eines integrierten Schaltungschips, mit einem Leiterrahmen, der einen Kühlkörper (3), an den der Chip (11) mittels Lot (12) zu bonden ist, sowie eine Mehrzahl von Leitungen (4, 5, 6) für die Verbindung mit Kontaktpunkten an dem Chip (11) vorsieht, und weiterhin mit einem Isoliergehäuse (2), das um Bereiche des Kühlkörpers (3) und der Leitungen (4, 5, 6) geformt ist und einen Hohlraum (7) vorsieht, in dem der Chip (11) mit einem unter diesem befindlichen Lot-Rohlung (12) zum nachfolgenden Schmelzen des Lot-Rohlings (12) aufzunehmen ist, um den Chip (11) an de Kühlkörper (3) zu bonden, dadurch gekennzeichnet, daß des Gehäuse (2) eine auf dem Kühlkörper (3) ausgebildete Bodenwand (9) aufweist, daß die Bodenwand (9) eine Öffnung (10) aufweist, durch die der Kühlkörper (3) zu dem Hohlraum (7) freiliegt, daß die Öffnung (10) eine derartige Form aufweist, daß sie den Chip (11) mit dem darunter liegenden Lot-Rohling (12) aufnimmt und den Chip (11) auf dem Kühlkörper (3) positioniert, und daß eine Anzahl von Lot-Aussparungen (13) um die Öffnung (10) herum angeordnet ist und mit dieser in Verbindung steht.

2. Anordnung nach Anspruch 1, dadurch gekennzeichnet, daß die Öffnung (10) in der Bodenwand (9) des Gehäuses (2) rechtwinklig ist und eine Lot-Aussparung (13) mit jeder Kante der Öffnung (10) in Verbindung steht.

3. Anordnung nach Anspruch 1 oder Anspruch 2, dadurch gekennzeichnet, daß drei Leitungen (4, 5, 6) vorgesehen sind, von denen eine Leitung (5) direkt mit dem Kühlkörper (3) verbunden ist und die anderen beiden Leitungen (4, 6) Bereiche aufweisen, die in Ausnehmungen (8) in dem Gehäuse (2) freiliegen und in Verbindung mit dem Hohlraum (7) stehen.

4. Anordnung nach einem der vorausgehenden Ansprüche, gekennzeichnet durch einen integrierten Schaltungschip (11), der in der Öffnung (10) in der Bodenwand (9) des Gehäuses (2) aufgenommen ist und mittels Lot (12), das sich zwischen dem Chip (11) und dem Kühlkörper (3) in der Öffnung (10) befindet, an dem Kühlkörper (3) befestigt ist, wobei sich in der Lot-Aussparung bzw. den Lot-Aussparungen (13) ebenfalls Lot (12) befindet.

5. Anordnung nach Anspruch 4 bei dessen Abhängigkeit von Anspruch 3, dadurch gekennzeichnet, daß Kontaktpunkte an dem Chip (11) mittels Leitern (14) mit den in den Ausnehmungen (8) freiliegenden Bereichen der anderen beiden Leitungen (4, 6) verbunden sind.

6. Anordnung nach Anspruch 5, dadurch gekennzeichnet, daß der Hohlraum (7) mit Isoliermaterial (15, 16) gefüllt ist, von dem wenigstens eine äußere Schicht (16) festgeworden ist.

7. Verfahren zum Herstellen einer Anordnung nach Anspruch 4, 5 oder 6, gekennzeichnet durch folgende Schritte: Positionieren eines Lot-Rohlings (12) und eines integrierten Schaltungschips (11) in der Öffnung (10) in der Bodenwand (9) des Gehäuses (2), wobei der Lot-Rohling (12) zwischen dem Chip (11) und dem Kühlkörper (3) liegt; Drängen des Chips (11) in Richtung auf den Kühlkörper (3) mit einer vorbestimmten Kraft; Erwärmen des Lot-Rohlings (12), um dadurch ein Schmelzen des Lot-Rohlings (12) zu verursachen, wobei die auf den Chip (11) ausgeübte Kraft das Lot (12) dann veranlaßt, eine bestimmte Dicke anzunehmen, und wobei überschüssiges Lot (12) in die Lot-Aussparungen (13) fließt; und danach Gestatten des Erhärtens des Lots (12) und somit Bonden des Chips (11) an den Kühlkörper (3).

8. Verfahren nach Anspruch 7, dadurch gekennzeichnet, daß der Lot-Rohling (12) unter Verwendung einer Induktionserwärmungs-Vorrichtung geschmolzen wird, mittels der ein Heizstrom in dem Lot-Rohling (12) induzierbar ist.

FIG.1.

FIG.2.

FIG.3.

FIG.4.

FIG.5.

FIG.6.

FIG.7.

FIG.8.

FIG.9.